(19)

Europäisches Patentamt
European Patent Office
Office européen des brevets

(11) **EP 3 101 682 A1**

(12) **EUROPEAN PATENT APPLICATION**

(43) Date of publication:
**07.12.2016 Bulletin 2016/49**

(51) Int Cl.:
**H01L 21/033** (2006.01)          **H01L 21/308** (2006.01)
**H01L 21/311** (2006.01)          **H01L 21/316** (2006.01)

(21) Application number: **15170519.1**

(22) Date of filing: **03.06.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **IMEC VZW**
**3001 Leuven (BE)**

(72) Inventors:
• **Altamirano Sanchez, Efrain**
  **3001 Leuven (BE)**
• **Tao, Zheng**
  **3001 Leuven (BE)**

(74) Representative: **Patent Department IMEC**
**IMEC vzw**
**Patent Department**
**Kapeldreef 75**
**3001 Leuven (BE)**

(54) **METHOD FOR PROVIDING A PATTERNED TARGET LAYER IN A SEMICONDUCTOR STRUCTURE**

(57)    A method for providing a patterned target layer in a semiconductor structure, the method comprising providing a semiconductor structure comprising a target layer to be patterned and on the target layer, a first hard mask layer, providing, overlying and in contact with the first hard mask layer, a patterning stack comprising a first sacrificial material, patterning the first sacrificial material, depositing a conformal layer of a spacer material on the patterning stack, patterning the conformal layer of the spacer material, patterning the first hard mask layer by etching, whereby the patterned spacer material is used as an etch mask, and providing the patterned target layer by etching the target layer using the patterned first hard mask layer as an etch mask, wherein the first sacrificial material is an amorphous carbon, and wherein the spacer material is a dielectric comprising oxygen and the conformal deposition of the layer of the spacer material is done at a temperature in the range of 50° C-75° C using an Atomic Layer Deposition (ALD) process.

400

| | |
|---|---|
| a. | Providing a semiconductor structure |
| b. | Providing a patterning stack comprising a first sacrificial material |
| c. | Patterning the first sacrificial material |
| d. | Depositing a conformal layer of a spacer material |
| e. | Patterning the conformal layer of the spacer material |
| g. | Patterning the first hard mask layer |
| h. | Providing a patterned target layer |

Figure 1

EP 3 101 682 A1

**Description**

**Technical Field of the invention**

The present invention is related to the field of lithography in semiconductor processing. More specifically, it is related to a method for patterning a target layer in a semiconductor structure that enables decreasing critical dimension while reducing line edge roughness and line width roughness. The present invention is also related to semiconductor structures comprising a patterned target layer obtained thereby.

**Background of the invention**

As the scaling of transistor sizes is continuing in order to keep up with Moore's Law, enabling smaller line widths, referred to as critical dimension (CD), is becoming ever significant since scaling goes beyond the limitations of photolithography. In the field of lithography of semiconductor processing, the technique called Self Aligned Double Patterning (SADP) involving 193 nm immersion (193i) lithography is one of the simplest ways of multiple patterning that enables CD reduction. SADP can be done twice that leads to the so-called Self Aligned Quadruple-Patterning (SAQP).
The SADP technique involves 193i lithography exposure that prints the target pattern, followed by a dry (plasma) etch step, which transfers the pattern to the hard-mask below the photoresist. During the transfer of the pattern, the dimension of the pattern needs to be scaled down to the actual CD required.
Currently, the scaling down to reach the actual CD required can be done via two approaches. The first approach involves trimming the photoresist with plasma and the second approach involves trimming the hard-mask with dry-etch plasma. After the trimming process, the pattern is transferred to an amorphous carbon layer (a-C), which will act as a core (sometimes called mandrel). A SiN or $SiO_2$ layer is deposited conformal using Plasma Enhanced Chemical Vapor Deposition (PECVD) on the a-C layer. Then a plasma etch is carried out in order to create the SiN or $SiO_2$ spacers on each lateral side of the core, which is made of a-C. Removal of the core leaves a new pattern defined by the spacers that now has reduced CD. The pattern can then be transferred to the underlying layers.
As scaling continues, controlling the variation of CD has also become a more significant and more of a challenging task. In order to cope with this challenging task, semiconductor industry is working hard in order to develop patterning processes that end up with smooth structures. In this respect, reducing Line Edge Roughness (LER) and Line Width Roughness (LWR) are important challenges. While LER is an important part of lithography process control, LWR is an important part of etch process control. LER may lead to serious device parameter fluctuations and performance limitations, while LWR correlates to an increase in transistor leakage current. Therefore, both LER and LWR have to be reduced as technology nodes get smaller.
According to the 2009 International Technology Roadmap for Semiconductors (ITRS) the LER value has to be below 1.3 nm in order to obtain a sub-22 nm technology node, referred to also as N22 technology node. This means LWR values of less than 1.8 nm. This requires sub 1.0 nm of line width roughness (LWR) and line edge roughness (LER) for N10 technologies and beyond, where N10 and beyond refers to the technology node(s) in semiconductor processing for devices having a gate length of 10 nm or lower. In order to achieve these values, 193i lithography needs to expose lines with LWR below 3 nm and LER below 2 nm. Plasma etching has to transfer these lines into the hard mask without damaging the LWR and LER. This is extremely challenging when the target line dimensions are in the sub 12 nm as in N10 technology or lower.
In US 8,889,560 B2, a method of forming fine patterns for a semiconductor device is disclosed, where photoresist pattern is used to create fine patterns in a carbon containing layer. Spacers of silicon nitride material are formed over opposing side walls of these fine patterns of carbon containing layer, where the carbon containing layer is provided by atomic layer deposition at a temperature of about 700°C or lower. Although the disclosure of US 8,889,560 B2 addresses that the width of the photoresist pattern, which will be used to form the fine patterns of the semiconductor device, maybe about several to tens of nm, controlling and reducing CD variation still remains to be a challenge.
Hence, there exists a need in the art for a method to pattern a target layer in a semiconductor structure offering CD reduction suitable for producing devices of N10 technology or lower while providing LWR and LER values less than 2 nm.

**Summary of the invention**

It is an object of embodiments of the present invention to provide methods for providing a patterned target layer in a semiconductor structure having LWR and LER values in the range of 1 nm and 2 nm.
It is an object of embodiments of the present invention to provide a semiconductor structure comprising, on a target layer, a patterned first hard mask layer having LWR and LER values in the range of 1 nm and 2 nm.
The above objective is accomplished by a method and a semiconductor device according to the present invention.

In a first aspect, the present invention relates to a method for providing a patterned target layer in a semiconductor structure. The method includes providing a semiconductor structure having a target layer to be patterned. On the target layer, there is a first hard mask layer. A patterning stack is provided overlying and in contact with the first hard mask layer. The patterning stack comprises a first sacrificial material. The first sacrificial material of the patterning stack is exposed. The first sacrificial material is an amorphous carbon. The first sacrificial material of the patterning stack is patterned. A conformal layer of a spacer material is deposited on the patterning stack and patterned, to thereby form a patterned spacer material. The first hard mask layer is patterned by etching, whereby the patterned spacer material is used as an etch mask. The patterned target layer is provided by etching the target layer using the patterned first hard mask layer as an etch mask. The spacer material is a dielectric comprising oxygen and the conformal deposition of the layer of the spacer material is done at a temperature in the range of 50 °C - 75 °C using an Atomic Layer Deposition (ALD) process.

In embodiments, the semiconductor structure may be an intermediate structure during the fabrication of a Field Effect Transistor (FET) in semiconductor processing for Integrated Circuit (IC) fabrication. The FET is preferably a fin-type FET (FinFET). If the semiconductor structure is an intermediate structure during the fabrication of a FinFET, the target layer may be a semiconductor layer. The semiconductor layer comprises Si or a III-V compound.

In embodiments, the semiconductor structure may also be an intermediate structure during interconnecting FETs with wiring on a wafer in semiconductor processing for IC fabrication. If the semiconductor structure is an intermediate structure during interconnecting FETs with wiring on a wafer, the target layer may be a dielectric layer.

The inventors have found out that using a spacer material that is a dielectric comprising oxygen and depositing the spacer material by ALD in the temperature range of 50 °C - 75 °C results in reduced Line Edge Roughness (LER) and reduced Line Width Roughness (LWR) of line structures that make up the patterned target layer.

It is, thus, an advantage of the embodiments of the present invention that LER and LWR of the patterned target layer is reduced.

In embodiments, the dielectric comprising oxygen may be $Al_2O_3$, $HfO_2$, $ZrO_2$ or $SiO_2$. In a particular embodiment, the dielectric comprising oxygen is $SiO_2$.

It is advantageous to use $SiO_2$ as the dielectric since it can be deposited by ALD at a temperature in the range of 50 °C - 75 °C, without the need to increase the process time for the ALD process. Thus, the in turn poses no challenge on the throughput in an IC fabrication environment.

In embodiments, the ALD process is a Plasma Enhanced ALD (PE-ALD) process. The PE-ALD process uses $O_2$ plasma. The inventors have found out that the interaction of the $O_2$ plasma with the patterned sacrificial material during the conformal deposition of the spacer material has influence on the reduction of LER/LWR. In embodiments, the PE-ALD process may be a direct plasma PE-ALD or a remote plasma PE-ALD process. A remote plasma PE-ALD process is advantageous when the patterned sacrificial material is sensitive to light, especially to vacuum ultraviolet (VUV) or ultraviolet (UV) light coming from the plasma itself.

In preferred embodiments, patterning the first sacrificial material may include providing a second hard mask layer overlying and in contact with the patterning stack. The second hard mask layer is patterned by performing a lithographic patterning step. The first sacrificial material is etched by using the patterned second hard mask layer as an etch mask.

In embodiments, the lithographic patterning step may be performed by 193 nm immersion (193i) lithography or by Extreme Ultraviolet (EUV) lithography.

In embodiments, the second hard mask layer may comprise a layer stack of a bottom antireflective coating (BARC) on top of a Si comprising mask layer. The Si comprising mask layer is overlying and in contact with the first sacrificial material of the patterning stack. The Si comprising mask layer may be a silicon nitride or a silicon oxy carbide layer. In preferred embodiments, the Si comprising mask layer is a silicon oxy carbide layer.

In embodiments, patterning the conformal layer of the spacer material comprises subjecting the semiconductor structure to an anisotropic etch process. The anisotropic etch process, thereby removes the spacer material from horizontal surfaces of the patterning stack. Thereafter, the first sacrificial material is selectively removed.

In embodiments, the patterning stack may further comprise a second sacrificial material. The second sacrificial material is in contact with the first hard mask layer. It is advantageous to have a second sacrificial material in the patterning stack. The allows obtaining line structures in the target layer having a CD value even smaller than those obtainable by the presence of the first sacrificial material. Furthermore, these line structures having even smaller CD values also exhibit reduced LER and LWR values. The method further comprises, following the step of patterning the conformal layer of the spacer material, the step of patterning the second sacrificial material by etching, whereby the patterned spacer material is used as an etch mask and the step of depositing a conformal layer of a spacer material and the step of patterning the conformal layer of the spacer material is repeated one time before patterning the first hard mask layer.

In embodiments, the repeated step of patterning the conformal layer of the spacer material may include subjecting the semiconductor structure to an anisotropic etch process. Subjecting the semiconductor structure to the anisotropic etch process removes the spacer material from the horizontal surfaces of the patterning stack. Thereafter, the second sacrificial material is selectively removed.

In preferred embodiments, the second sacrificial material is an amorphous silicon layer.

In alternative embodiments, the second sacrificial material is an amorphous carbon layer and the patterning stack further comprises an etch stop layer sandwiched between the first sacrificial material and the second sacrificial material. It is advantageous to have an etch stop layer between the first and the second sacrificial material when both are amorphous carbon so that etching of the second sacrificial amorphous carbon layer is avoided during the step of patterning the first sacrificial amorphous carbon layer.

In a second aspect, the invention relates to a semiconductor structure comprising a patterned first hard mask layer present on a target layer. The patterned first hard mask layer contains a plurality of exposed, equally-spaced, free standing, parallel line structures. These line structures have a pitch value in the range of 16 nm to 32 nm. These line structures have a LER value in the range of 1 nm to 2nm. The LER value is measured by CD-SEM. It is advantageous to have a semiconductor structure comprising a patterned first hard mask layer containing line structures with a pitch value in the range of 16 nm to 32 nm and having a LER value in the range of 1 nm to 2 nm since it enables forming a patterned target layer having a LER value of 1 nm to 2 nm.

In embodiments of the second aspect, the target layer may be a dielectric layer or a semiconductor layer comprising Si or a III-V compound. If the target layer is a dielectric layer, the dielectric layer may be $SiO_2$ or a dielectric layer having a k-value higher than $SiO_2$. If the target layer.

In embodiments of the second aspect, the patterned first hard mask layer has a critical dimension uniformity (CDU) defined by a three sigma value of 0.4 nm. It is advantageous to have a patterned first hard mask layer having a CDU with a $3\sigma$ value of 0.4 nm since it enables forming the underlying target layer having uniform line structures.

**Brief description of the figures**

Figure 1 is a flowchart representing a method according to an embodiment.

Figure 2a to 2i show the process steps according to an embodiment of the method represented in the flowchart of Fig. 1.

Figure 3a shows a cross section Transmission Electron Microscopy (X-TEM) image of a semiconductor structure comprising a patterned semiconductor target layer (5) corresponding to Fig. 2h.

Figure 3b shows a Critical Dimension Scanning Electron Microscopy (CD-SEM) image of a semiconductor structure comprising a patterned semiconductor target layer (5) corresponding to Fig. 2h.

Figure 4 is a flowchart representing a method according to another embodiment.

Figure 5a to 5m show the process steps according to another embodiment of the method represented in the flowchart of Fig. 4.

Figure 6 is a tilted view of a schematic representation of a semiconductor structure (310) comprising a patterned semiconductor target layer (5, 5') after removal of the patterned first hard mask layer (200, 201).

Figure 7 is a tilted view of a schematic representation of a semiconductor structure (320) comprising a patterned dielectric target layer (5") after removal of the patterned first hard mask layer (200, 201).

Figure 8 shows Table 1.

**Detailed description of the invention**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of the description.

The following terms are provided solely to aid in the understanding of the invention.

As used herein and unless provided otherwise, the term *"critical dimension (CD)"* refers to the width of individual line structures that are displaced parallel and equally spaced from each other, and that are free standing.

As used herein and unless provided otherwise, the term *"line width roughness (LWR)"* refers to the variation of the line width.

As used herein and unless provided otherwise, the term *"line edge roughness (LER)"* refers to the variation of the edges of the line with respect to the ideal case, which is when there are no variations present.

As used herein and unless provided otherwise, the term *"low-k dielectric"* refers to insulating films having a dielectric constant lower than that of $SiO_2$.

As used herein and unless provided otherwise, the term *"exposed"* refers to a layer or a feature to be in contact with air and that there is no other layer deposited on and/or covering the layer or the feature.

As used herein and unless provided otherwise, the term *"scaling"* refers to a reduction in the width of features or line structures.

As used herein and unless provided otherwise, the term *"unit cycle"* in a Plasma Enhanced Atomic Layer Deposition (PEALD) process refers to a sequence consisting of steps of pulsing, separately, with a precursor gas and a plasma exposure and pulsing with a purge gas in between the precursor gas and plasma exposure.

As used herein and unless provided otherwise, the term *"pitch"* is defined as the summation of the separation distance between two line structures on a layer and the width of one of these line structures.

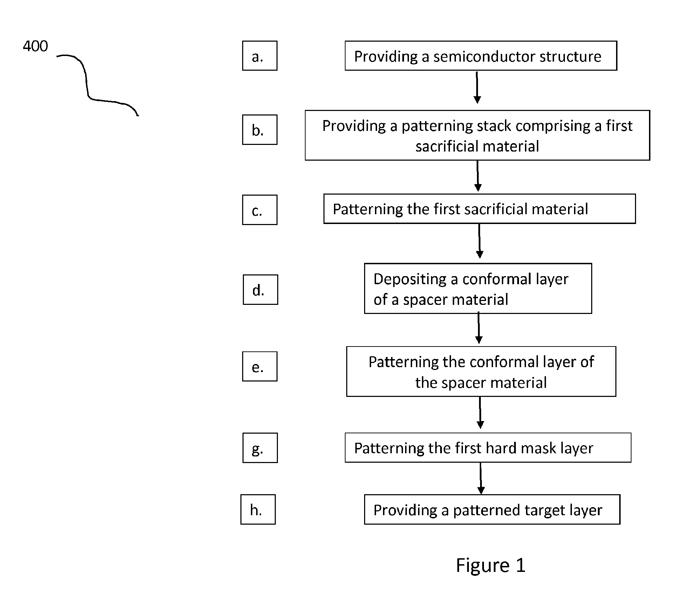

Figure 1 is a flowchart representing a method according to an embodiment.

The method (400) starts with (step a) providing a semiconductor structure. The semiconductor structure comprises a target layer (10) to be patterned. On the target layer, there is a first hard mask layer (20). The target layer (10) may be a semiconductor layer or a dielectric layer.

The semiconductor may be suitable for forming fin structures for making fin type field effect transistors (FinFETs) in the Front End of Line (FEOL) processing of IC fabrication. The semiconductor layer comprises silicon or is a III-V compound. The semiconductor layer may be a single layer comprising silicon or a single layer of a III-V compound. The semiconductor layer may also be a semiconductor layer stack comprising multiple silicon-comprising layers or multiple III-V compound layers or combinations of silicon-comprising layers and III-V compound layers. The silicon comprising semiconductor may be monocrystalline silicon, silicon germanium or combinations thereof. The III-V compound may be a III-V binary, ternary or quaternary material. Preferably, the semiconductor layer is monocrystalline silicon.

The target layer may also be a dielectric layer. The dielectric layer may be suitable for use as an inter-layer or intra-layer dielectric in the Back End of Line (BEOL) processing of IC fabrication. When the dielectric layer is patterned, the semiconductor structure is ready for metallization to form the interconnect structures. The dielectric may be silicon dioxide, a low-k dielectric having a k-value lower than that of silicon dioxide or a replacement low-k dielectric.

The first hard mask layer is a hard mask layer stack comprising at least a silicon nitride layer. Preferably, the silicon nitride layer is $Si_3N_4$. The thickness of the silicon nitride layer is in the range of 20 nm to 40 nm. Preferably, the thickness is 30 nm.

Etching the hard mask layer may, thus, comprise one or more etching steps, which are for example, based on different etching chemistries suitable for etching different sub-layers of the hard mask layer stack.

A patterning stack is provided overlying and in contact with the first hard mask layer (20). (step b). The patterning stack comprises a first sacrificial material (30) on the first hard mask layer (20).

The first sacrificial material is patterned to, thereby, form a patterned first sacrificial material (80) (step c). The patterned first sacrificial material (80) is defined by plurality of equally-spaced, free-standing, parallel line structures (35). The top surface and the lateral walls of each of these line structures are exposed. The patterned first sacrificial material (80) may be an ashable material, which can be easily removed by an ashing process as known to persons skilled in the art. Preferably, the ashable material is amorphous carbon. The thickness of the patterned first sacrificial material is in the range of 30 nm to 60 nm. Preferably, the thickness is 50 nm.

A spacer material (90) is deposited on the patterning stack (step d). The thickness ($t_1$) of the spacer material is in the range of 7 nm to 15 nm. The spacer material is conformally deposited on the patterning stack thereby, following the topography provided by the patterned first sacrificial material (80). The conformal deposition of the spacer material is preferably done by Atomic Layer Deposition (ALD) process.

A patterned spacer material (100) is formed (step e). The patterned spacer material is defined by plurality of equally-spaced, free-standing, parallel line structures (96). The top surface and the lateral walls of each of these line structures are exposed.

A patterned first hard mask layer (200) is formed by etching the first hard mask layer (20) using the patterned spacer material (100) as a first etch mask (step g). The patterned first hard mask layer (200) contains a plurality of equally-spaced, free-standing, parallel line structures (25)). The top surface and the lateral walls of each of these line structures are exposed. Etching the first hard mask layer may be done by using dry etching as known to persons skilled in the art.

The patterned first hard mask layer (200) is used as a second etch mask to etch the target layer (10), to thereby create a patterned target layer (5, 5', 5") (step h). The patterned target layer (5, 5', 5") is defined by plurality of equally-spaced, free-standing, parallel line structures (15, 17, 15'). The top surface and the lateral walls of each of these line structures are exposed.

In the present invention, the spacer material (90) is, preferably, a dielectric comprising oxygen. The deposition of the oxygen comprising dielectric, which is used as the spacer material, is done by using Atomic Layer Deposition (ALD) process.

ALD process is a vapor phase deposition technique, where layer by layer deposition is achieved by performing two half-cycles that are repeated subsequent to each other, wherein each half cycle ends with a purge step. In a first half cycle, the surface is subjected to a precursor gas and in the second half cycle the surface containing the adsorbed precursor is subjected to a reactant gas. The purge step done after each half cycle removes the residual precursor or reactant species from the surface.

The inventors have found out that depositing the oxygen comprising dielectric by using ALD at a temperature in the range of 50 °C -100 °C, preferably, in the range of 50 °C - 75 °C, is advantageous since such low temperatures avoid the stripping of the patterned sacrificial material. Such low temperatures also avoid the distortion of the profile of the patterned sacrificial material during the deposition of the spacer material. Stripping or distortion of the patterned sacrificial material is unwanted since the influences the desired CD, thus leading to reliability and device performance problems.

The oxygen comprising dielectric may be a metal oxide that can be deposited by ALD. The metal oxide may be $Al_2O_3$, $HfO_2$, $ZrO_2$ or $SiO_2$. More specifically, the oxygen comprising dielectric is $SiO_2$. $Al_2O_3$, $HfO_2$ and $ZrO_2$ is usually deposited at high temperatures, of about 300 °C, by the ALD process, that provides the required high throughput values suitable for processing in a fab. However, such high deposition temperatures makes these aforementioned metal oxides undesirable due to the possibility of stripping of the patterned sacrificial material or distortion of the profile of the patterned sacrificial material. Even though these metal oxides may be deposited at lower temperatures than 300 °C, such deposition conditions have adverse effects on the throughput of the process. $SiO_2$, in this respect, can be deposited at low temperatures as disclosed by the method of the present invention, thus avoiding such undesirable outcomes or impacting throughput of the deposition process.

The ALD process, in embodiments of the preset invention, may be a thermal ALD process or a Plasma Enhanced Atomic Layer Deposition (PE-ALD) process. In a thermal ALD process the surface reactions are thermally driven. In a PE-ALD process the surface is exposed to species generated by a plasma during the second half-cycle, which is when the surface containing the adsorbed precursor is subjected to a reactant gas.

In preferred embodiments of the present invention, the ALD process is a PE-ALD process.. Preferably, an $O_2$ plasma is used in the second half cycle.

The inventors have found out that using PE-ALD process with $O_2$ plasma exposure for the deposition of the spacer material leads to reduced LWR and LER values of the patterned sacrificial material after spacer material deposition. Without wishing to be bound by theory, the reduction in LWR and LER values of the patterned sacrificial material are thought to originate from a smoothening effect occurring on the patterned sacrificial material due to the $O_2$ plasma exposure. Therefore, when the spacer material is deposited by the PE-ALD process, the line structures of the patterned spacer material eventually have lower LWR and LER values compared to the LWR and LER values of the patterned sacrificial material before the spacer material deposition. Reduced LWR and LER values of the patterned spacer material are transferred to the first hard mask layer during the formation of the patterned first had mask layer such that the line structures of the patterned first hard mask layer (200) have LWR and LER values lower than 1.5 nm. Furthermore, etching the target layer using the patterned first hard mask layer as an etch mask provides a patterned target layer (5, 5', 5") having LWR and LER values thus, below 1.5 nm.

The PE-ALD process may be a direct plasma or a remote plasma PE-ALD process. In a direct plasma PE-ALD process, there is the influence of vacuum ultraviolet (VUV) or ultraviolet (UV) light coming from the plasma itself. Therefore, in the case when a light sensitive sacrificial material is used, such for example patterned photoresist, remote plasma may be advantageous for depositing the spacer material over the patterned photoresist.

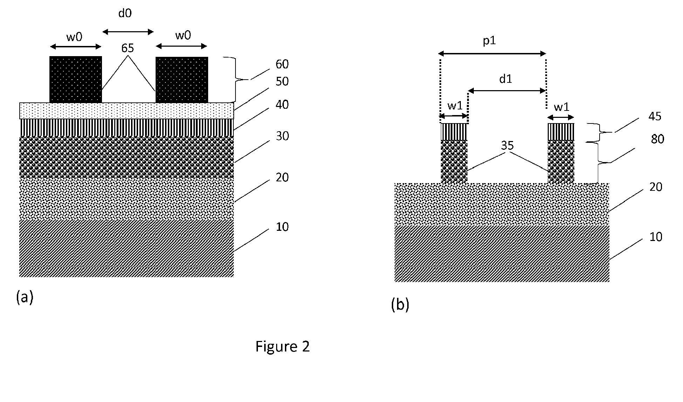

Figures 2a-i represent schematically the process steps according to an embodiment of the method represented in the flowchart of Fig. 1. The figures show corresponding cross sections of the semiconductor structure at different stages in the embodiment.

The method comprises providing a patterning stack overlying and in contact with the first hard mask layer (20) comprised in the semiconductor structure. This first had mask layer is in contact with the target layer (10).

Figures 2a-c represent schematically a possible option of providing the patterning stack.

As shown in Figure 1a, the first hard mask layer (20) is deposited on the target layer (10) covering the target layer. Within the context of the invention, depositing or providing a layer or a material "on" another layer or "on" another material is foreseen as depositing or providing the layer or the material directly or with one or more intermediate layers in between. Accordingly, the first hard mask layer (20) is, preferably, directly deposited on the target layer (10). The first hard mask layer is a hard mask layer stack comprising at least a silicon nitride layer. Preferably, the silicon nitride layer is $Si_3N_4$. The thickness of the silicon nitride layer is in the range of 10 nm to 50 nm. Preferably, the thickness is 30 nm. The $Si_3N_4$ layer of the hard mask layer stack may be in direct contact with the target layer. The $Si_3N_4$ layer is deposited by Low Pressure Chemical Vapor Deposition (LPCVD) or Plasma Enhanced Chemical Vapor Deposition (PECVD).

A sacrificial material (30) is deposited, preferably directly, on the first hard mask layer (20). The sacrificial material is an amorphous carbon. The amorphous carbon may be deposited by Chemical Vapor Deposition (CVD). Preferably, the amorphous carbon is deposited by PECVD.

A second hard mask layer is, preferably directly, deposited on the sacrificial material (30). The second hard mask layer may comprise a layer stack of a bottom antireflective coating (BARC) (50) on top of a Si comprising mask layer (40). The Si comprising mask layer is overlying and in contact with the first sacrificial material of the patterning stack. The Si comprising mask layer may be a silicon nitride or a silicon oxy carbide layer. In preferred embodiments, the Si comprising mask layer is a silicon oxy carbide layer.

The silicon oxy carbide layer is deposited by PECVD at a thickness in the range of 5-50 nm. Preferably, the thickness is 15 nm.

A patterned photoresist layer (60) is provided, preferably, directly on the BARC layer. In an example, the thickness of the BARC layer is 67 nm.

The patterned photoresist is obtained by depositing a photoresist layer suitable for 193 nm immersion lithography process. After lithographic exposure and development of the photoresist layer, a patterned photoresist layer (60) including plurality of exposed, equally-spaced, free-standing photoresist lines (65) is obtained. Each of the photoresist features (65) have an initial width value ($w_0$). In an example, the thickness of the patterned photoresist is 105 nm. In an example, the pitch (po), being the summation of $w_0$ and do, of the patterned photoresist (60) is 90 nm.

Before transferring the pattern of the patterned photoresist (60) to the underlying layers, the width of the photoresist features needs to be scaled down to the actual width (CD) required. Scaling down the width of the pattern in the context refers to the reduction of the initial width ($w_0$) of the photoresist lines (65) to a second width (w1).

Scaling down the dimension can be performed by two different approaches.

The first approach may be applied before the BARC opening step. The photoresist lines (65) can be trimmed such that the initial width ($w_0$) of the photoresist lines are be reduced to the actual CD required ($w_1$). After the trimming process, BARC layer is opened by using Chlorine plasma-Oxygen plasma to remove the BARC layer from the horizontal surfaces that are not masked by the patterned photoresist layer to, thereby, expose the Si comprising mask layer mask layer (40). Subsequently, the pattern is transferred to the Si comprising mask layer (40) and to the first sacrificial material (30) by performing a dry etch process. After the dry etch process, the patterned photoresist layer and BARC layer is stripped, to thereby form a patterned first sacrificial material (80) with a patterned Si comprising mask layer atop (45)(Fig. 2b).

The second approach may be applied after the BARC opening step and after subsequently transferring the pattern into the Si comprising mask layer (40) creating plurality of exposed, equally spaced parallel line structures having a width equal to the initial width ($w_0$) of the patterned photoresist features. Trimming the patterned Si comprising mask layer reduces the width ($w_0$) of the line structures of the patterned Si comprising mask layer (40) to the actual width ($w_1$) required. Performing a dry etch process using the patterned Si comprising mask layer (45) as an etch mask creates a patterned first sacrificial material (80) covered by a patterned second hard mask layer (45). The patterned first sacrificial material (80) is defined by plurality of equally-spaced, free-standing, parallel line structures (35). Top surfaces of each of these line structures (35) of the patterned first sacrificial material (80) are covered by the patterned Si comprising mask layer (45). (Fig. 2b).

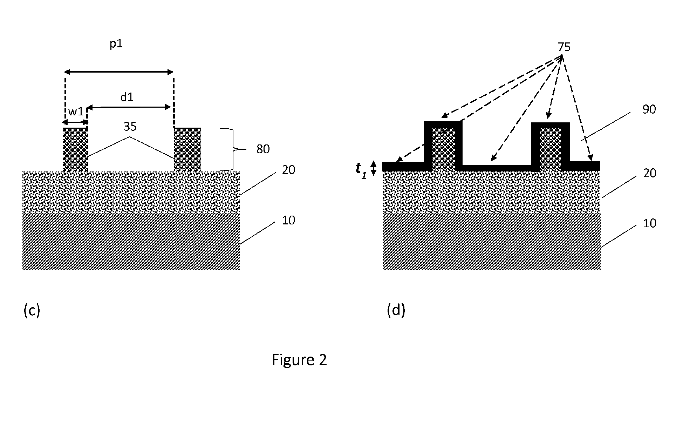

Removal of the patterned Si comprising mask layer in both the aforementioned approaches is done by using an fluorine-based chemistry. The fluorine-based chemistry is applied during a wet etching process. The fluorine-based chemistry is hydrogen fluoride. Removal of the patterned Si comprising mask layer (45) creates plurality of equally-spaced, free-standing, parallel line structures (35) of the patterned first sacrificial material that are exposed (Fig. 2c). Each of these line structures of the patterned first sacrificial material have a width value (w1) with a separation distance (d1) in between. These line structures (35) of the patterned first sacrificial material (80) have a first pitch value, (p1) (Fig. 2b). The first pitch value (p1) of the line structures of the patterned sacrificial material equals the summation of the width value (w1) and the separation distance (d1) (Fig. 2c).

Figure 2d shows schematically the deposition of a spacer material (90) conformally on the patterned sacrificial layer (80). The spacer material (90) is an oxygen comprising dielectric. The oxygen comprising dielectric may be a metal oxide. The metal oxide may $Al_2O_3$, $HfO_2$, $ZrO_2$ or $SiO_2$. Preferably, the oxygen comprising dielectric is $SiO_2$ and is deposited directly on the patterned first sacrificial material (80). The conformal deposition is done using a Plasma Enhanced Atomic Layer Deposition (PEALD). In PEALD, a structure is exposed to the species generated by a plasma during the second half of the unit cycle. In the first half of the unit cycle, the surface is exposed to a precursor gas.

In the present invention, the semiconductor structure is exposed to a metal precursor gas in the first half of the unit cycle followed subsequently by a first purge step. In the second half of the unit cycle, following the first purge step, the semiconductor structure is exposed to a plasma. Preferably, the plasma exposure is an $O_2$ plasma exposure, which is subsequently followed by a second purge step. The first and the second purge step is done by using an inert gas such as Ar gas or $N_2$. The deposition temperature is in the range of 50°C - 75° C. and chamber pressure is about 400 Pa.

The spacer material is deposited to a thickness in the range of 3 nm to 25 nm. Preferably, the thickness ($t_1$) is in the range of 8 nm to 15 nm. More preferably, the thickness is 10 nm.

Subsequent to the conformal deposition of the spacer material (90) by PEALD process, the semiconductor structure is loaded into a dry-etch plasma reactor. The dry-etch plasma reactor is, preferably, a Inductively Coupled Plasma (ICP) reactor. The semiconductor structure is subjected to an anisotropic etch to thereby remove the spacer material from the horizontal surfaces (75) (Fig. 2d). Horizontal surfaces (75) of the semiconductor structure correspond to the top of the line structures (35) of the patterned first sacrificial material and to the top of the first hard mask layer (20) that is not covered by the line structures (35) of the patterned first sacrificial material.

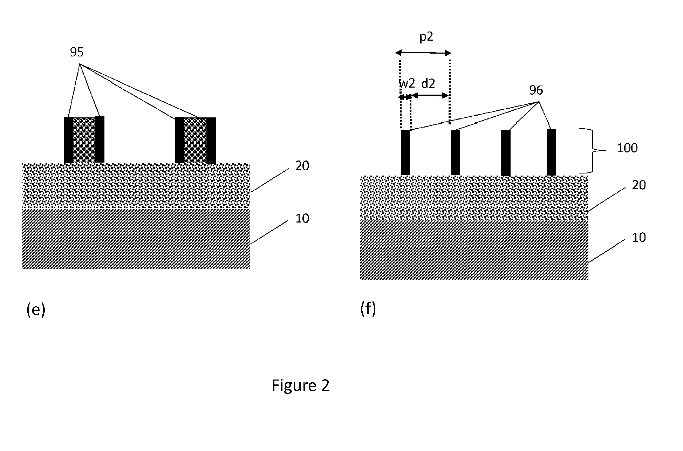

In an example, the anisotropic etch is done under $CF_4$ gas at 3 mtorr, an ICP power of 200 Watts, with 50 V bias in the Inductively Coupled Plasma (ICP) reactor. Once the anisotropic etch is completed (Fig. 2e), spacers (95) are formed on each lateral sidewall of the line structures (35) of the patterned first sacrificial material (80). These spacers are in physical contact with these lateral sidewalls of these line structures (35).

An strip (ashing) process is performed to remove the patterned first sacrificial material or in other words, the line structures (35) of the patterned sacrificial material (80) from the semiconductor structure. The strip process is an isotropic strip process and is done under pure 02 gas at a 10mtorr, ICP power of 1000 Watts, with 40 V bias. Removal of the patterned first sacrificial material (80) forms a patterned spacer material (100) on the first hard mask layer (20) as schematically shown in Fig. 2f. The patterned spacer material (100) is defined by plurality of exposed, equally-spaced, free-standing, parallel line structures (96). These line structures (96) of the patterned spacer material have a second pitch value, ($p_2$). These line structures have a width value ($w_2$) that is equal to the thickness ($t_1$) of the spacer material originating from the conformal deposition. These line structures (96) are separated from each other by a distance value of (d2). The pitch value ($p_2$) of these line structures (96) of the patterned spacer material (100) is given by the summation of the width ($w_2$) and the distance ($d_2$) between them.

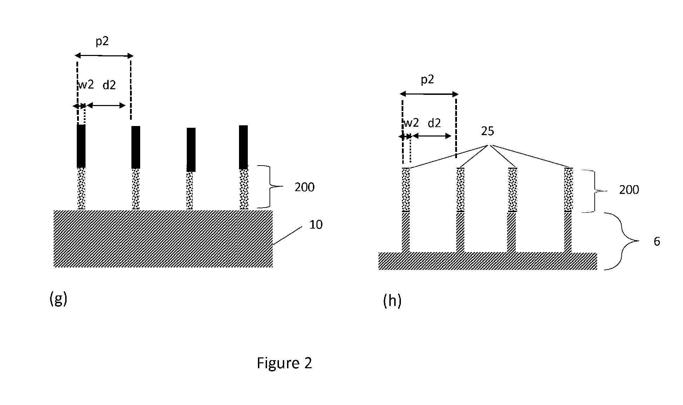

The patterned spacer material (100) is then used as a first etch mask to transfer its pattern into the first hard mask layer (20) to thereby create a patterned first hard mask layer (200). Pattern transfer into the first hard mask layer is done by a dry etch process. The dry etch process is an anisotropic dry etch process having a 5:1 selectivity to the patterned spacer material (100). The patterned first hard mask layer (200) contains a plurality of exposed, equally-spaced, free-standing, parallel line structures (25) covered by spacers (100) (Fig. 2g). These line structures of the patterned first hard mask layer has the same width ($w_2$), the same distance ($d_2$) in between and the same pitch value ($p_2$) as the line structures of the patterned spacer material (100).

The patterns in the patterned first hard mask layer is transferred to the target layer (10). The is done by performing an dry-etch process, whereby the patterned first hard mask layer (200) is used as a second etch mask. Since spacer pattern is used as an etch mask, the patterned first hard mask is still fully present on the patterned target layer after the completion of the dry etch process (Fig. 2h). The remaining spacers (100) are removed with a wet HF clean. The first hard mask layer is used as a chemical mechanical polishing stopping layer for STI formation as known to persons skilled in the art.

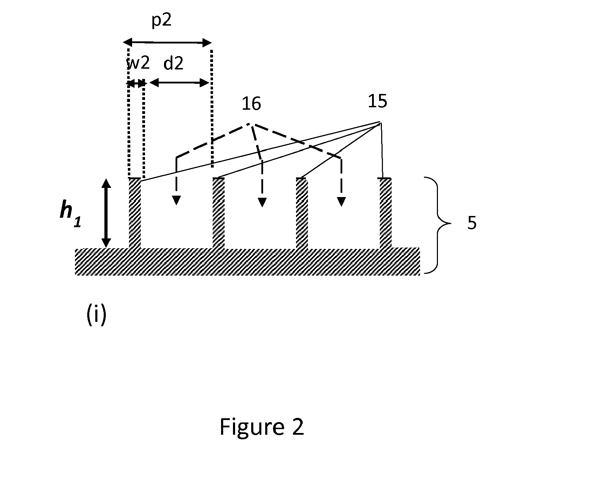

The patterned target layer (5) contains a plurality of exposed, equally-spaced, free-standing, parallel line structures (15) (Fig. 2i). The line structures (15) of the patterned target layer (5) has the same width ($w_2$), the same distance ($d_2$) in between and the same pitch value ($p_2$) as the line structures (25) of the patterned first hard mask layer (200) (Fig. 2h).

These line structures (15) are separated from each other by the trenches (16) that are formed in the target layer. The depth (h1) of these trenches (16) depends on the type of the target layer(10) that is patterned (Fig. 2i).

The patterned target layer may be a semiconductor layer that is suitable to form fin structures for making fin type field effect transistors (FinFETs) in the FEOL processing of IC fabrication. The depth ($h_1$) of these trenches (16) are then determined according to the technology node. For example, for N7 technology or beyond, the depth of these trenches (16) are in the range of 70 nm - 140 nm.

The patterned target layer may be a dielectric that is suitable for use as an inter-layer dielectric in the BEOL processing of IC fabrication. These trenches (16) of the dielectric then have a depth value ($h_1$) depending on the technology node. For example, for BEOL processing of N7 technology or beyond, the depth of these trenches (16) is in the range of 30 nm - 50 nm. suitable for metallization.

Comparison of the pitch value ($p_1$) of the line structures of the patterned sacrificial material (80) (Fig. 2c) and that ($p_2$) of the patterned target layer (5) (Fig. 2i) indicates that pitch value ($p_2$) of the patterned target layer is double of the pitch value ($p_1$) of the patterned sacrificial material (80). Therefore, the process steps disclosed according to the embodiment of the present invention results in SADP.

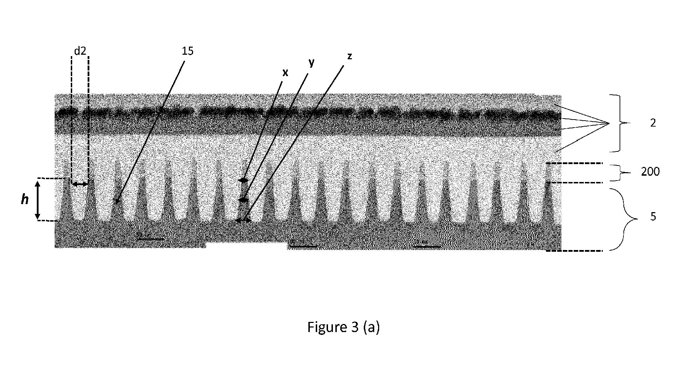

Figure 3a shows a cross section Transmission Electron Microscopy (X-TEM) image of a semiconductor structure comprising a patterned semiconductor target layer (5) obtained according to an embodiment of the method as schematically represented in Fig. 2h. The patterned target layer (5) is a monocrystalline Si layer. The TEM image is taken subsequent to the formation of the patterned target layer (5) and prior to the removal of the patterned first hard mask layer (200). The TEM image also shows the layers (2) deposited necessary for TEM imaging and do not necessarily represent layers that are part of the semiconductor structure disclosed in the present invention. The line structures of the patterned first hard mask layer (200) are bending due to TEM sample preparation.

The TEM image shows line structures (15) having a height ($h_1$) of approximately 61 nm. The distance (d2) between these line structures as measured in the upper part of the trenches is approximately 33 nm.

The width of these line structures (15) are analyzed at three different locations along the height ($h_1$) of these line structures. These three locations refer namely to the *top width* (x), which is measured within the top 2 % of the height ($h_1$), to the *middle width* (y), which is measured in the middle of the height ($h_1$) and to the *bottom width* (z), which is measured within the bottom 2 % of the height ($h_1$). The values for (x), (y) and (z) are averaged for each of these lines (15) to obtain the average width or in other words to get the mean value for the width of each of these lines.

LWR values of these line structures (15) are less than 1 nm defined according to the TEM image. The LWR is defined as the critical dimension uniformity (CDU) among these line (fin) structures. The smaller the value for CDU, the lower the LWR will be. Several TEM images were taken in order to define the local CDU and predict indirectly the LWR value.

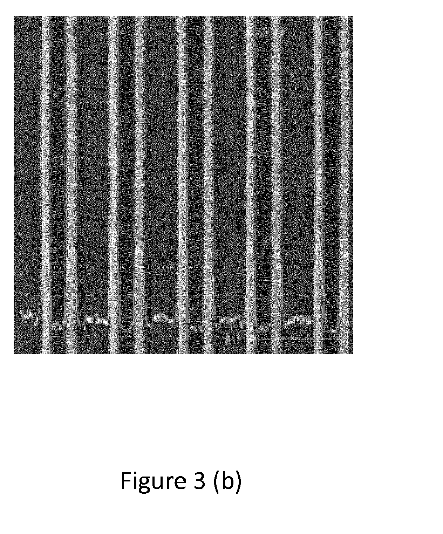

The LER values of these line structures are less than 1.5 nm as determined by Critical Dimension Scanning Electron Microscopy (CD-SEM) technique (Fig. 3b). The LER measurement is typically carried out in the following manner. There are CD-SEM lines/structures present on every die present on the wafer. Typically, the CD-SEM lines of 32 of these dies are imaged using a Scanning Electron Microscope (SEM). These 32 dies are chosen on the wafer such that they are uniformly separated from each other. A set of top-down images were captured on these CD-SEM lines using a certain beam current, for example 8 pA, and a certain accelerating voltage, for example, 500 V. In the case of photoresist LER analysis, for example, the parameters were chosen to reduce damage while preserving the signal to noise ratio and respecting the International Technology Roadmap for Semiconductors (ITRS) requirements. A rectangular scanning mode was used to acquire SEM images with a 512 x 512 pixel resolution. The mode allows to obtain different magnifications in the x and y directions, 300 kX and 49 kY respectively. The field of view (FoV) is 0.450 x 2.755 $\mu$m2 giving a pixel size of 0.88 x 5.38 nm2.

The ITRS specifications which requests a 2 $\mu$m line length that need to be measured in order to collect a minimum of 90 % of the roughness spectrum. Thirty-two frames were captured for each image. The SEM images were then analyzed off-line on the computer using a software suitable for such an analysis as known to persons skilled in the art to determine the LER values.

Consequently, these LER values are used to obtain the standard deviation, sigma value ($\sigma$), for LER using the standard deviation formula known to persons skilled in the art. LER and LWR are correlated by following relation and standard deviation for LER is used to obtain the standard deviation for LWR;

$$\sigma_{LWR} \;=\; 2^{1/2}\; \sigma_{LER} \qquad (1)$$

with $\sigma_{LWR}$ and $\sigma_{LER}$ representing the standard deviation of the LWR and LER values. In that way, LWR and LER are not independent from each other: when LER decreases, LWR decreases.

The critical dimension uniformity (CDU) across the wafer is calculated based upon the measurement of the width or CD of each of these line structures (15) using CD-SEM technique as outlined above. Multiplication of the sigma value by three gives the $3\sigma$ value for CD uniformity across the wafer. The 3-sigma ($\sigma$) value of the CDU across the wafer is found out to be 0.4 nm.

Thus, the process steps disclosed according to the embodiment of the present invention results with the advantage that LWR and LER values of the line structures (15) of the patterned target layer (5) is reduced in comparison to those obtained by using conventional SADP methods.

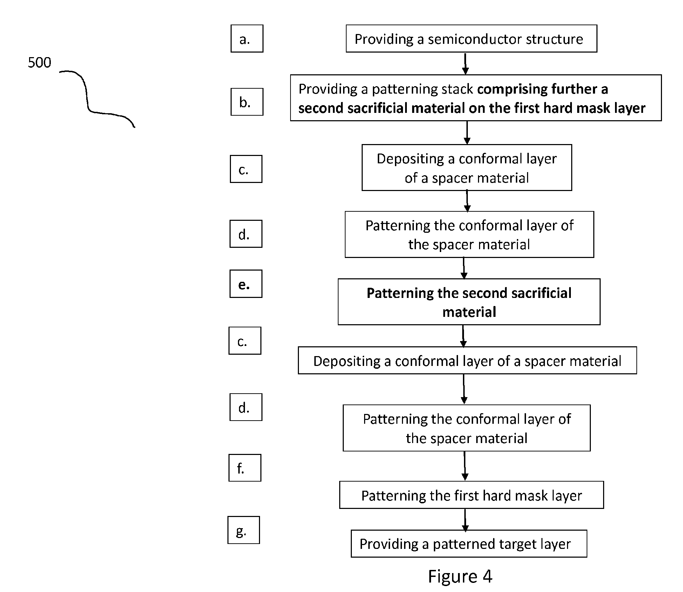

Figure 4 is a flowchart representing a method according to another embodiment.

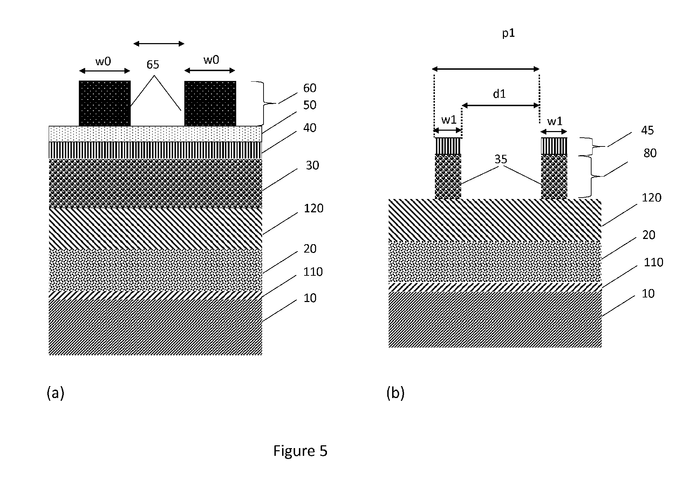

Figure 5a to 5m show the process steps according to another embodiment of the method represented in the flowchart of Fig. 4. The figures show corresponding cross sections of the semiconductor structure at different stages in the embodiment.

The method comprises providing a patterning stack overlying and in contact with the first hard mask layer. This first hard mask layer is in contact with the target layer (10).The patterning stack further comprises a second sacrificial material (120) directly on the first hard mask layer. A silicon oxide layer ($SiO_x$) (110) is present sandwiched between the first hard mask layer (20) and the target layer to be patterned (10). The thickness of the silicon oxide layer (110) is, preferably, 2 nm. The silicon oxide layer is needed for the Shallow Trench Isolation (STI) formation and it serves as an etch stop layer when the first hard mask layer is removed by the use of hot $H_3PO_4$.

Figures 5a-c represent schematically a possible option of providing, on the first hard mask layer (20), the patterning stack that further comprises the second sacrificial material (120). In this respect, process steps shown in Fig. 5a-c are analogous to those shown in Fig. 2a-c. The value for critical dimension of the line structures (35) of the patterned first sacrificial material (80) may, for example be 32 nm. This means the width ($w_1$) of the line structures of the patterned first sacrificial material is 32 nm.

The second sacrificial material may be an amorphous carbon layer or an amorphous silicon layer.

When the second sacrificial material (120) is an amorphous carbon layer, the thickness of the second sacrificial material is in the range of 30 nm to 100 nm. Preferably, the thickness is 40 nm. In this case, the patterning stack further comprises a silicon oxide layer. The silicon oxide layer (not shown in the figures) is sandwiched between the second sacrificial material (120) and the patterned first sacrificial material (80). The thickness of the silicon oxide layer is preferably 2 nm. The purpose of the silicon oxide layer is to act as an etch stop layer when patterning the first sacrificial material (30), to, thereby, form the first patterned sacrificial material (80).

When the second sacrificial material is an amorphous silicon layer, the thickness of the second sacrificial material is in the range of 30 nm to 100 nm. Preferably, the thickness is 50 nm. In this case, use of a silicon oxide layer between the first and the second sacrificial material is not necessary since the second sacrificial material is likely not to be etched during patterning of the first sacrificial material.

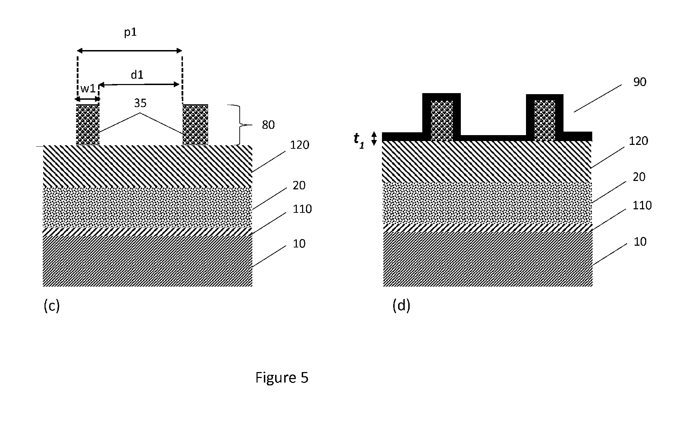

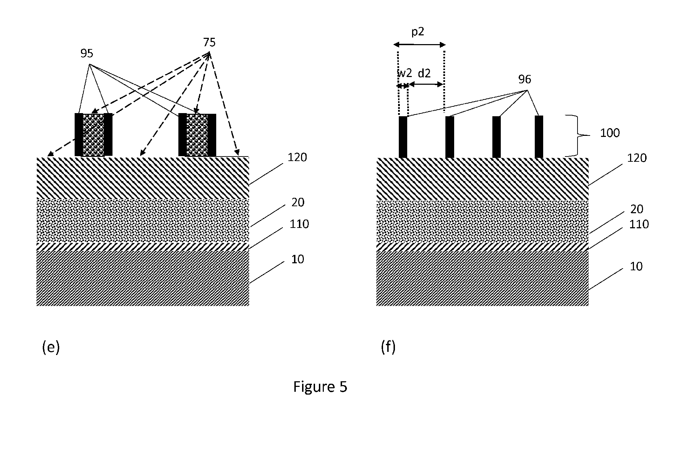

Figures 5d-f represent schematically the process steps for the deposition of the spacer material (90) and creation of the patterned spacer material (100), which are analogous to those shown in Fig. 2d-f. The value for critical dimension of the line structures (96) of the patterned spacer material (100) is 14-16 nm. (Fig. 5f).

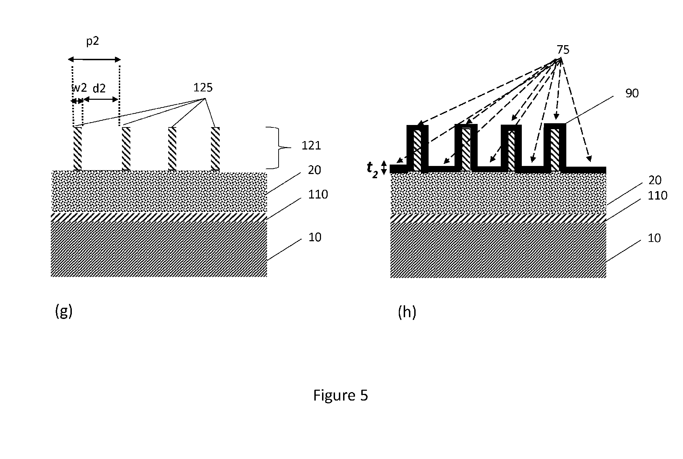

The patterned spacer material (100) is then used a third etch mask to transfer its pattern into the second sacrificial material by using a dry etching process as known to persons skilled in the art (120). After the completion of the dry etching process, the patterned spacer material (100) is removed from the semiconductor structure to thereby create a patterned second sacrificial material (121). The patterned second sacrificial material (121) is defined by plurality of exposed, equally-spaced, free-standing, parallel line structures (125) (Fig. 5g). These line structures of the patterned second sacrificial material (121) has the same width ($w_2$), the same distance ($d_2$) and the same pitch value ($p_2$) as the line structures (96) of the patterned spacer material (100) schematically shown in Fig. 5f. Thus, the value for critical dimension ($w_2$) of the line structures (125) of the patterned second sacrificial material (121) is 14-16 nm. (Fig. 5f).

In the case when the second sacrificial material is an amorphous carbon, which is same as the first sacrificial material, the portions of the silicon oxide layer (not shown in the figures) that are exposed and bounded by the line structures (96) of the patterned spacer material (100) are etched during the transfer of the pattern to the second sacrificial material (120) done by the dry etch process. After the completion of the dry etching process, removal of the patterned spacer material and the silicon oxide layer from the semiconductor structure forms the patterned second sacrificial material (121) (Fig. 5g).

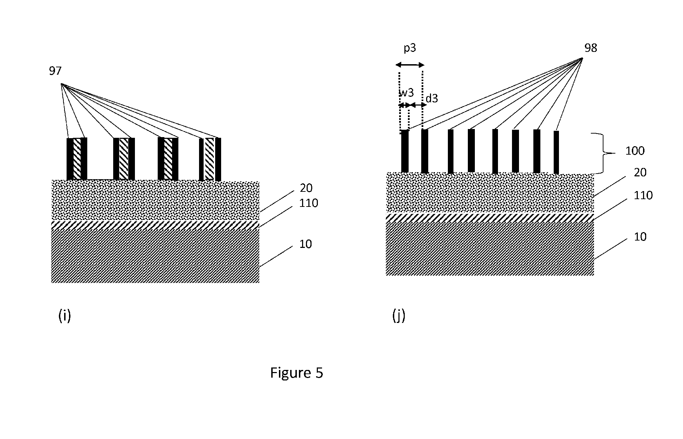

The steps of depositing the spacer material (90) and forming the patterned spacer material is repeated one more time. In this repetition sequence, the spacer material (90) is deposited, preferably directly, on the patterned second sacrificial material. (Fig. 5h) The thickness of the spacer material in this case is, preferably, 10 nm. Removal of the spacer material (90) from the horizontal surfaces of the semiconductor structure (Fig. 5i) is done by subjecting the semiconductor structure to an anisotropic etch process. Horizontal surfaces (75) of the semiconductor structure correspond to the top of the line structures (125) of the patterned second sacrificial material (121) and to the top of the first hard mask layer (20) that is not covered by the line structures (125) of the patterned second sacrificial material (121).

In an example, the anisotropic etch is done under $CF_4$ gas at 3 mtorr, an ICP power of 200 Watts, with 50 V bias in the Inductively Coupled Plasma (ICP) reactor. Once the anisotropic etch is completed, spacers (97) are formed on each lateral sidewall of the line structures (125) of the patterned second sacrificial material (121). These spacers are in physical contact with these lateral sidewalls of these line structures (125).

A strip (ashing) process is performed to remove the patterned second sacrificial material or in other words, the line structures (125) of the patterned second sacrificial material (121) from the semiconductor structure. The strip process is an isotropic strip process and is done under pure 02 gas at a 10mtorr, ICP power of 1000 Watts, with 40 V bias.

The patterned spacer material (100) formed after removal of the patterned second sacrificial material (121) by the ashing process at the end of the repetition sequence forms the patterned spacer material (100). The patterned spacer material (100) is defined by plurality of exposed, equally-spaced, free-standing, parallel line structures (98) (Fig. 5j). The value for critical dimension ($w_3$) of the line structures (98) of the patterned spacer material (100) is 10 nm. (Fig. 5f).

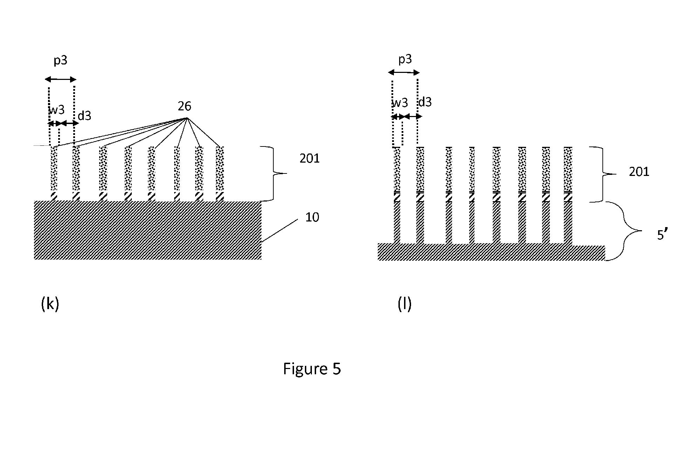

The patterned spacer material (100) is used as a first etch mask to etch the first hard mask layer to thereby create the patterned first hard mask layer (201) (Fig. 5k) Pattern transfer into the first hard mask layer is done by a dry etch process. The dry etch process is an anisotropic dry etch process having a 5:1 selectivity to the patterned spacer material (100). During the dry etch process, silicon oxide layer (110) is also opened, forming patterned silicon oxide layer (111), thereby exposing the target layer (10).

The patterns in the patterned first hard mask layer (201) is transferred to the target layer (10). This is done by performing a dry-etch process, whereby the patterned first hard mask layer (201) is used as a second etch mask. (Fig. 5l)

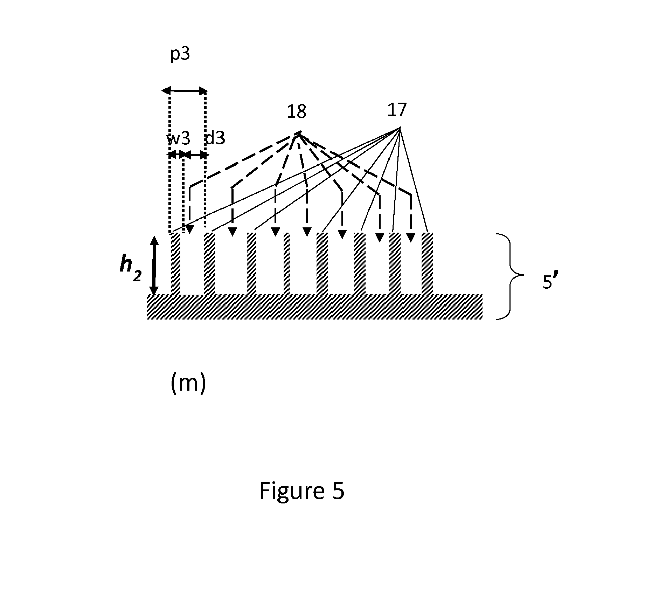

Since patterned first hard mask layer is used as an etch mask, the patterned first hard mask layer may still be present on the patterned target layer after the completion of the dry etch process (Fig. 5l). Removal of the patterned first hard mask layer from the semiconductor structure, thereby, creates the patterned target layer (5') (Fig. 5m).

The patterned target layer (5') is defined by plurality of exposed, equally-spaced, free-standing, parallel line structures (17). The line structures (17) of the patterned target layer (5') has the same width ($w_3$), the same distance ($d_3$) in between and the same pitch value ($p_3$) as the line structures (26) of the patterned first hard mask layer (201).

Comparison of the pitch value ($p_1$) of the line structures of the patterned sacrificial material (80) (Fig. 5b) and that ($p_3$) of the patterned target layer (5') (Fig. 5m) indicates that pitch value ($p_3$) of the patterned target layer is a quarter of the pitch value ($p_1$) of the patterned sacrificial material (80). Therefore, the process steps disclosed according to the embodiment of the present invention results in SAQP. SAQP is obtained, in this embodiment, by applying SADP two times. In this respect, the first SADP process takes place as represented in Fig. 5b to 5f and the second SADP process takes place as represented in Fig. 5g to 5j.

These line structures (17) are separated from each other by the trenches (18) that are formed in the target layer (10). The depth (h2) of these trenches (18) depends on the type of the target layer (10) that is patterned.

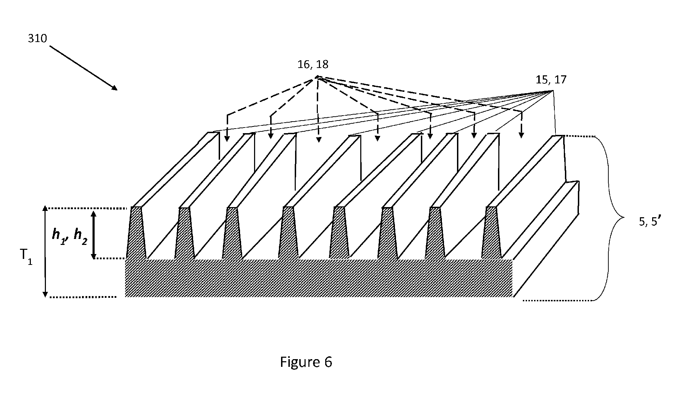

Figure 6 is a tilted view of a schematic representation of a semiconductor structure (310) comprising a patterned semiconductor target layer (5, 5') after removal of the patterned first hard mask layer (200, 201). The line structures (15) are formed within the thickness of the target layer (10) and are separated by trenches (16, 18). The line structures (15, 17) have a height ($h_1, h_2$) that is lower than the initial thickness ($T_1$) of the target layer (10). The means that when the pattern from the patterned first hard mask layer (200, 201) is transferred to the target layer (10), the target layer (10) has been etched partially to form the line structures (15, 17) having a height of ($h_1, h_2$). When the target layer (10) is a semiconductor suitable to form fin structures for making FinFETs, the semiconductor structure comprising a patterned target layer can be represented as that shown in Fig. 3a. Such a patterned target layer may be obtained by performing a SADP process or a SAQP process according to embodiments of the present invention. Fin structures are then formed by these line structures (15, 17) using the STI-approach as known to persons skilled in the art.

Furthermore, an SADP process may be performed according to embodiments of the present invention to obtain gate structures of FinFETs.

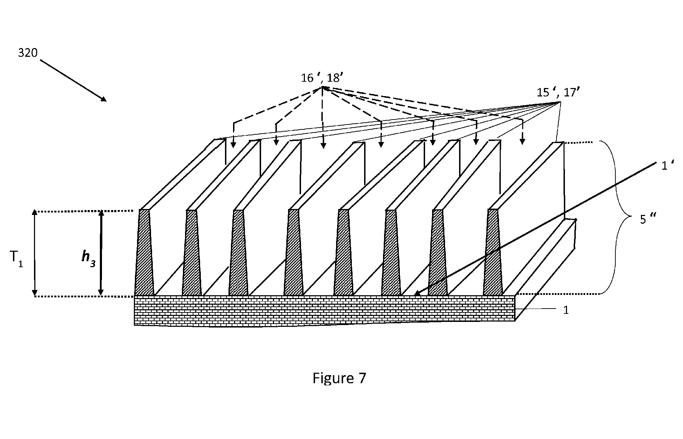

Figure 7 shows schematic representation of a semiconductor structure (320) comprising a patterned dielectric target layer (5"). The patterned target layer (5") is defined by plurality of exposed, equally-spaced, free-standing, parallel line structures (15', 17') separated by trenches (16', 18').

The line structures (15', 17') are formed throughout the thickness of the target layer (10) and are separated by trenches (16', 18'). The line structures (15', 17') have a height ($h_3$) that is equal to the initial thickness ($T_1$) of the target layer (10). The means that when the pattern from the patterned first hard mask layer (200, 201) is transferred to the target layer (10), the target layer (10) has been etched throughout its thickness to form the line structures (15', 17') to thereby expose the surface (1') of the underlying layer (1) at the bottom of the trenches (16', 18'). When the target layer (10) is a dielectric layer suitable to use as an inter-layer dielectric for separating interconnect structures, the semiconductor structure comprising a patterned target layer can be represented as that shown in Fig. 6. Interconnect structures are then formed within the trenches (16', 18').

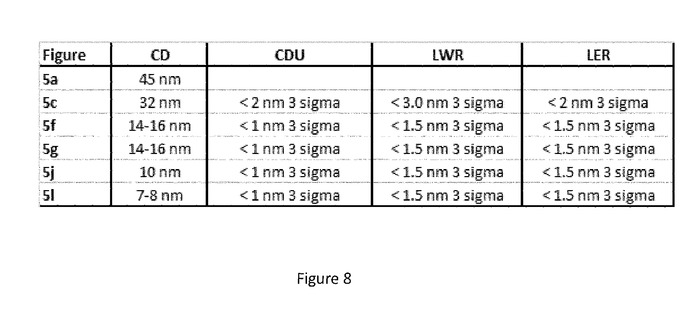

Table 1 presented in Fig. 8 shows an example, where the values obtained for CD, CDU, LWR and LER after several of the processing steps that are schematically represented in Fig. 5 are presented. CD value refer to the width of the line structures of the patterned layer in question. In this example, initial pitch value for the patterned photoresist (60) is 90 nm. After a trimming process to scale down the width of the patterned photoresist feature, a width value of 32 nm is obtained for features of the patterned first sacrificial material (80).

After completion of the first SADP process, which is presented by Fig. 5f, CD is halved from 32 nm down to 14-16 nm in comparison with the CD of the patterned first sacrificial material as presented in Fig. 5c. In addition, a remarkable reduction in LWR and LER is obtained going from a value of less than 3.0 nm $3\sigma$ (LWR)and less than 2.0 nm $3\sigma$ (LER) to a value of less than 1.5 nm $3\sigma$ (LWR)and less than 1.5 nm $3\sigma$ (LER). Completion of the second SADP process and forming the patterned target layer, which is presented by Fig. 5l, marks also the completion of the SAQP process. It is observed that the CD is reduced to one quarter of the starting CD value of 32 nm, while the remarkable reduction in LWR and LER is transferred to the patterned target layer.

This shows that a method according to embodiments of the present invention can facilitate obtaining a reduced LWR and LER value in the target layer to be patterned when SADP or SAQP process is used for CD reduction.

SADP or SAQP process according to embodiments of the present method can be performed on semiconductor structures comprising a patterned photoresist layer that is obtained by 193 immersion lithography or by EUV lithography.

**Claims**

1.  A method for providing a patterned target layer in a semiconductor structure, the method comprising:

    a. providing a semiconductor structure comprising:

       i. a target layer to be patterned,
       ii. on the target layer, a first hard mask layer,

    b. providing, overlying and in contact with the first hard mask layer, a patterning stack comprising a first sacrificial material,
    c. patterning the first sacrificial material,
    d. depositing a conformal layer of a spacer material on the patterning stack,
    e. patterning the conformal layer of the spacer material,
    g. patterning the first hard mask layer by etching, whereby the patterned spacer material is used as an etch mask, and;
    h. providing the patterned target layer by etching the target layer using the patterned first hard mask layer as an etch mask, wherein the first sacrificial material is an amorphous carbon,
    **characterized in that**;
    the spacer material is a dielectric material comprising oxygen and the conformal deposition of the layer of the spacer material is done at a temperature in the range of 50° C-75° C using an Atomic Layer Deposition (ALD) process.

2.  The method according to claim 1, wherein the dielectric material comprising oxygen is $SiO_2$.

3.  The method according to claim 1 or 2, wherein the ALD process is a Plasma Enhanced Atomic Layer Deposition (PE-ALD) process.

4.  The method according to claim 1, wherein patterning the first sacrificial material comprises:

    i. providing a second hard mask layer overlying and in contact with the patterning stack,
    ii. patterning the second hard mask layer by performing a lithographic patterning step,
    iii. etching the first sacrificial material by using the patterned second hard mask layer as an etch mask.

5.  The method according to any of claims 1 to 4, wherein patterning the conformal layer of the spacer material comprises :

    i. subjecting the semiconductor structure to an anisotropic etch process, to thereby remove the spacer material from horizontal surfaces of the patterning stack, and ,

ii. thereafter removing selectively the first sacrificial material.

6. The method according to any of claims 1 to 5, wherein the patterning stack further comprises a second sacrificial material, wherein the second sacrificial material is in contact with the first hard mask layer and the method further comprises, following
step (e), the step of (f) patterning the second sacrificial material by etching, whereby the patterned spacer material is used as an etch mask, and repeating, one time, step (d) and (e) prior to step (g).

7. The method according to claim 6, wherein the repeated step of patterning the conformal layer of the spacer material comprises :

   i. subjecting the semiconductor structure to an anisotropic etch process, to thereby remove the spacer material from horizontal surfaces of the patterning stack, and;
   ii. thereafter removing selectively the second sacrificial material.

8. The method according to any of claims 6 to 7, wherein the second sacrificial material is an amorphous silicon layer.

9. The method according to claims 6 to 7, wherein the second sacrificial material is an amorphous carbon layer and the patterning stack further comprises an etch stop layer sandwiched between the first sacrificial material and the second sacrificial material.

10. The method according to claim 1, wherein the target layer is a dielectric layer or a semiconductor layer comprising Si or a III-V compound.

11. A semiconductor structure comprising a patterned first hard mask layer present on a target layer, wherein the patterned first hard mask layer contains a plurality of exposed, equally-spaced, free-standing, parallel line structures having a pitch value in the range of 16 nm to 32 nm
**characterized in that**,
the line structures have a LER value in the range of 1 nm to 2 nm.

12. The semiconductor structure according to claim 11, wherein the target layer is a dielectric layer or a semiconductor layer comprising Si or a III-V compound.

13. The semiconductor structure according to claim 11 or 12, wherein the patterned first hard mask layer has a critical dimension uniformity defined by a three sigma value of 0.4 nm.

400

| a. | Providing a semiconductor structure |

| b. | Providing a patterning stack comprising a first sacrificial material |

| c. | Patterning the first sacrificial material |

| d. | Depositing a conformal layer of a spacer material |

| e. | Patterning the conformal layer of the spacer material |

| g. | Patterning the first hard mask layer |

| h. | Providing a patterned target layer |

Figure 1

(a)

(b)

Figure 2

Figure 2

Figure 2

Figure 2

Figure 2

Figure 3 (a)

Figure 3 (b)

500

a. | Providing a semiconductor structure

b. | Providing a patterning stack **comprising further a second sacrificial material on the first hard mask layer**

c. | Depositing a conformal layer of a spacer material

d. | Patterning the conformal layer of the spacer material

e. | **Patterning the second sacrificial material**

c. | Depositing a conformal layer of a spacer material

d. | Patterning the conformal layer of the spacer material

f. | Patterning the first hard mask layer

g. | Providing a patterned target layer

Figure 4

(a)

(b)

Figure 5

Figure 5

(e)

(f)

Figure 5

(g)

(h)

Figure 5

(i)

(j)

Figure 5

(k)                                          (l)

Figure 5

p3

18    17

w3  d3

$h_2$

5'

(m)

Figure 5

310

16, 18

15, 17

$h_1, h_2$

$T_1$

5, 5'

Figure 6

320

16 ', 18'

15 ', 17'

1 '

5 "

1

$T_1$

$h_3$

Figure 7

| Figure | CD | CDU | LWR | LER |
|---|---|---|---|---|
| 5a | 45 nm | | | |
| 5c | 32 nm | < 2 nm 3 sigma | < 3.0 nm 3 sigma | < 2 nm 3 sigma |
| 5f | 14-16 nm | < 1 nm 3 sigma | < 1.5 nm 3 sigma | < 1.5 nm 3 sigma |
| 5g | 14-16 nm | < 1 nm 3 sigma | < 1.5 nm 3 sigma | < 1.5 nm 3 sigma |
| 5j | 10 nm | < 1 nm 3 sigma | < 1.5 nm 3 sigma | < 1.5 nm 3 sigma |
| 5l | 7-8 nm | < 1 nm 3 sigma | < 1.5 nm 3 sigma | < 1.5 nm 3 sigma |

Figure 8

Europäisches
Patentamt

European
Patent Office

Office européen
des brevets

# EUROPEAN SEARCH REPORT

Application Number

EP 15 17 0519

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/126042 A1 (PASQUALE FRANK L [US] ET AL) 7 May 2015 (2015-05-07) * paragraphs [0029] - [0048]; figures 1-11 * * paragraphs [0053] - [0061], [0073], [0103], [0105]; figures 12-18; table 1 * | 1-13 | INV. H01L21/033 H01L21/308 H01L21/311 H01L21/316 |
| X | US 2014/170853 A1 (SHAMMA NADER [US] ET AL) 19 June 2014 (2014-06-19) * paragraphs [0061] - [0089]; figures 2A-15C * * paragraphs [0031] - [0036]; figure 1A * | 1-13 | |
| X | US 2013/105983 A1 (MIN JIN-HO [KR] ET AL) 2 May 2013 (2013-05-02) * paragraphs [0064] - [0104]; figures 3-18 * | 1-13 | |
| X A | US 2014/363963 A1 (KIYOTOSHI MASAHIRO [JP]) 11 December 2014 (2014-12-11) * paragraphs [0008] - [0046]; figures 1-12 * | 11-13 1-10 | |
| X A | US 2015/115418 A1 (WEI ANDY [US] ET AL) 30 April 2015 (2015-04-30) * paragraphs [0001] - [0003], [0053] - [0056]; figures 10-17 * * paragraphs [0061] - [0065]; figures 23-35 * | 11-13 1-10 | TECHNICAL FIELDS SEARCHED (IPC) H01L |
| X | WO 2009/009418 A1 (MICRON TECHNOLOGY INC [US]; GREELY JOSEPH NEIL [US]; MORGAN PAUL [US];) 15 January 2009 (2009-01-15) * paragraphs [0002], [0003], [0030] * | 11-13 | |
| X A | EP 2 378 543 A2 (ASM GENITECH KOREA LTD [KR]) 19 October 2011 (2011-10-19) * paragraphs [0018] - [0021], [0028] - [0030]; figures 3A-3D * | 11-13 1-10 | |

The present search report has been drawn up for all claims

| Place of search | Date of completion of the search | Examiner |
|---|---|---|
| The Hague | 28 October 2015 | Szarowski, Anne |

# EP 3 101 682 A1

## ANNEX TO THE EUROPEAN SEARCH REPORT
## ON EUROPEAN PATENT APPLICATION NO.

EP 15 17 0519

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2015

| Patent document cited in search report | | Publication date | Patent family member(s) | | Publication date |
|---|---|---|---|---|---|
| US 2015126042 | A1 | 07-05-2015 | CN | 104752199 A | 01-07-2015 |
| | | | JP | 2015111668 A | 18-06-2015 |
| | | | KR | 20150053253 A | 15-05-2015 |
| | | | US | 2015126042 A1 | 07-05-2015 |
| US 2014170853 | A1 | 19-06-2014 | TW | 201503228 A | 16-01-2015 |
| | | | US | 2014170853 A1 | 19-06-2014 |
| US 2013105983 | A1 | 02-05-2013 | KR | 20130046812 A | 08-05-2013 |
| | | | US | 2013105983 A1 | 02-05-2013 |
| | | | US | 2014332970 A1 | 13-11-2014 |
| US 2014363963 | A1 | 11-12-2014 | NONE | | |
| US 2015115418 | A1 | 30-04-2015 | US | 2015115418 A1 | 30-04-2015 |
| | | | US | 2015287595 A1 | 08-10-2015 |
| WO 2009009418 | A1 | 15-01-2009 | CN | 101960560 A | 26-01-2011 |
| | | | EP | 2179439 A1 | 28-04-2010 |
| | | | JP | 2010533378 A | 21-10-2010 |
| | | | KR | 20100039886 A | 16-04-2010 |
| | | | TW | 200924059 A | 01-06-2009 |
| | | | US | 2009017627 A1 | 15-01-2009 |
| | | | US | 2012015520 A1 | 19-01-2012 |
| | | | WO | 2009009418 A1 | 15-01-2009 |
| EP 2378543 | A2 | 19-10-2011 | EP | 2378543 A2 | 19-10-2011 |
| | | | JP | 5756325 B2 | 29-07-2015 |
| | | | JP | 2011228707 A | 10-11-2011 |
| | | | KR | 20110115101 A | 20-10-2011 |
| | | | TW | 201207898 A | 16-02-2012 |
| | | | US | 2011256727 A1 | 20-10-2011 |

EPO FORM P0459

For more details about this annex : see Official Journal of the European Patent Office, No. 12/82

**EP 3 101 682 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8889560 B2